# DEMANDE DE BREVET EUROPEEN

(11) **EP 3 540 950 A1**
(43) Date de publication de la demande: **18.09.2019**
(21) Numéro de dépôt: 19162607.6
(22) Date de dépôt: 13.03.2019
(51) Int. Cl.: H04B 1/3877, A63H 30/04, G05D 1/00, G08C 17/02, F16B 2/02, F16M 11/00, F16C 11/00, H05K 5/02, H05K 7/14

(54) **DISPOSITIF DE COMMANDE À DISTANCE, PAR EXEMPLE POUR COMMANDER UN DRONE À DISTANCE**

(30) Priorité: 13.03.2018 FR 1852137
(71) Demandeur: Parrot Drones, 75010 Paris (FR)
(72) Inventeur: KELLER, Thibaud, 75010 PARIS (FR); CAUBEL, Christine, 75014 PARIS (FR)
(74) Mandataire: Lavoix

(57) **Abrégé**

Le dispositif de commande à distance comprend un corps principal (12) et un ensemble de support (14) configuré pour recevoir un appareil électronique mobile (6) de manière amovible et le maintenir, l'ensemble de support (14) possédant une configuration de rangement et une configuration d'utilisation permettant de recevoir l'appareil électronique mobile (6), le dispositif de commande à distance étant configuré de telle sorte que le passage de la configuration de rangement à la configuration d'utilisation commande la mise sous tension du dispositif de commande à distance.

## Description

La présente invention concerne le domaine des dispositifs de commande à distance prévu pour commander à distance un appareil télécommandé, par exemple un aéronef sans pilote à bord, aussi appelé « drone ».

Il est possible de munir un dispositif de commande à distance d'un ensemble de support configuré pour recevoir un appareil électronique mobile, tel qu'une téléphone mobile ou une tablette numérique, afin d'utiliser un écran de l'appareil électronique mobile pour l'affichage, par exemple de paramètres relatifs à l'appareil télécommandé et/ou d'images prises par un appareil de capture d'image embarqué sur l'appareil télécommandé.

WO2017/177453A1 divulgue un dispositif de commande à distance comprenant un ensemble de support pour recevoir un appareil électronique mobile tel qu'un téléphone portable, l'ensemble de support possédant une configuration de rangement pour faciliter le transport et une configuration d'utilisation dans laquelle l'ensemble de support est déployé pour recevoir l'appareil électronique mobile. Le dispositif de commande à distance comprend un corps principal portant des manettes de commande et des boutons de commande. L'ensemble de support comprend un élément de support monté coulissant sur le corps principal pour recevoir l'appareil électronique entre le corps principal et l'élément de support, ou deux éléments de support montés rotatif sur le corps principal et prévus pour recevoir l'appareil électronique mobile entre deux.

Un tel dispositif de commande à distance nécessite de nombreuses manipulations avant de pouvoir être utilisé, ce qui rend sa mise en oeuvre compliquée.

Un des buts de l'invention est de proposer un dispositif de commande à distance dont l'utilisation soit facilitée.

A cet effet, l'invention propose un dispositif de commande à distance comprenant un corps principal et un ensemble de support configuré pour recevoir un appareil électronique mobile de manière amovible et le maintenir, l'ensemble de support possédant une configuration de rangement et une configuration d'utilisation permettant de recevoir l'appareil électronique mobile, le dispositif de commande à distance étant configuré de telle sorte que le passage de la configuration de rangement à la configuration d'utilisation commande la mise sous tension du dispositif de commande à distance.

Lors du déploiement de l'ensemble de support pour monter un appareil électronique mobile sur le dispositif de commande à distance, le dispositif de commande à distance est automatiquement mis sous tension, sans que l'utilisateur ait à actionner un bouton de mise sous tension. Il en résulte que le nombre d'opérations à réaliser par l'utilisateur pour activer le dispositif de commande à distance est réduit, ce que facilite l'utilisation du dispositif de commande à distance.

Dans des modes de réalisation particuliers, le dispositif de commande à distance comprend une ou plusieurs des caractéristiques optionnelles suivantes, prise individuellement ou selon toutes les combinaisons techniquement possible :
- il comprend un interrupteur commandant la mise sous tension/hors tension du dispositif de commande à distance, l'interrupteur étant disposé de manière à être commandé du fait du passage de l'ensemble de support de la configuration de rangement à la configuration d'utilisation ;
- l'interrupteur possède un organe d'actionnement mobile disposé de manière à être actionné du fait du passage de l'ensemble de support de la configuration de rangement à la configuration d'utilisation ;
- l'ensemble de support est lié au corps principal par une articulation ;
- l'organe d'actionnement est placé de manière à être caché par l'ensemble de support en configuration de rangement ;
- l'organe d'actionnement est placé dans un dégagement ménagé dans le corps principal pour permettre le débattement de l'ensemble de support entre la configuration de rangement et la configuration d'utilisation ;
- il comprend un système antennaire de radiocommunication pour l'émission et/ou la réception de signaux radiofréquences, le système antennaire étant porté par l'ensemble de support ;
- le passage de l'ensemble de support de la configuration de rangement à la configuration d'utilisation entraîne le positionnement de du système antennaire en position d'émission et/ou réception ;
- en configuration de rangement, l'ensemble de support est rabattu contre le corps principal et, en configuration d'utilisation, l'élément de support s'étend à partir du corps principal et à l'écart du corps principal ;
- l'ensemble de support possède une première partie et une deuxième partie délimitant entre elle un espace de réception de l'appareil électronique mobile, la première partie étant montée mobile sur le corps principal pour passer la configuration de rangement à la configuration d'utilisation, la deuxième partie étant montée mobile sur la première partie de manière à régler l'ensemble de support en fonction de dimensions de l'appareil électronique mobile ;
- il comprend des organes de commande situés sur le corps principal et actionnables par un utilisateur pour générer des instructions.

L'invention et ses avantages seront mieux compris à la lecture de la description qui va suivre, donnée uniquement à titre d'exemple non limitatif et faite en référence aux dessins annexés, sur lesquels :
- la Figure 1 est une vue en perspective d'un dispositif de commande à distance muni d'un ensemble de support, l'ensemble de support étant en configuration de rangement ;
- la Figure 2 est une vue en perspective du dispositif de commande à distance, l'ensemble de support étant en configuration d'utilisation ;
- la Figure 3 est une vue en perspective du dispositif de commande à distance, un appareil électronique mobile étant monté sur l'ensemble de support ;
- la Figure 4 est une vue en perspective éclatée du dispositif de commande à distance.

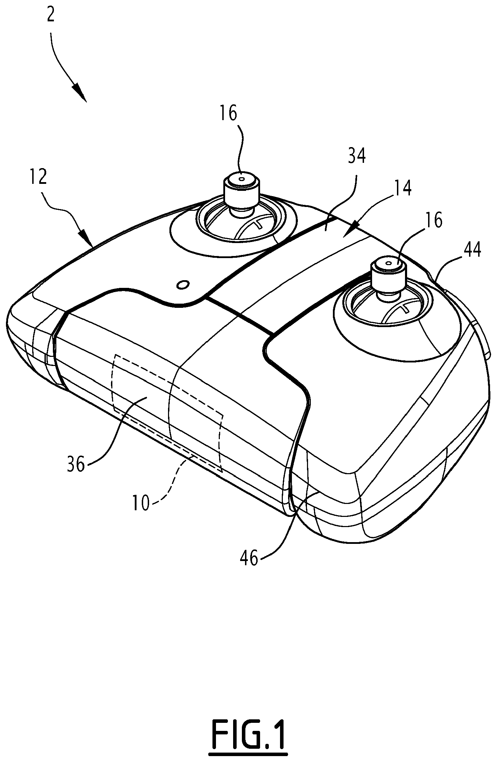

Le dispositif de commande à distance 2 des Figures 1 à 4, est configuré pour commander à distance un appareil télécommandé 4.

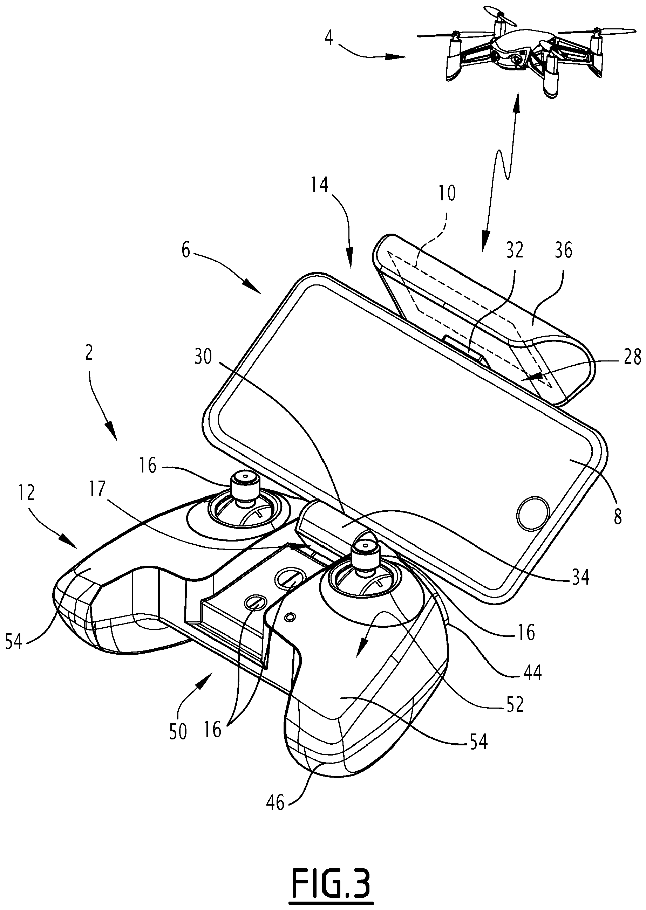

L'appareil télécommandé 4 est par exemple un véhicule télécommandé. Tel qu'illustré sur la Figure 3, l'appareil télécommandé 4 est un aéronef sans pilote à bord, aussi appelé « drone », ici un drone à voilure tournante.

Le dispositif de commande à distance 2 est aussi appelé « télécommande », et en particulier « radiocommande » lorsque la communication avec l'appareil télécommandé 4 est réalisée par ondes radiofréquence.

Le dispositif de commande à distance 2 est configuré pour recevoir un appareil électronique mobile 6 de manière amovible (Figure 3). L'appareil électronique mobile 6 reçu sur le dispositif de commande à distance 2 est alors solidaire de ce dernier.

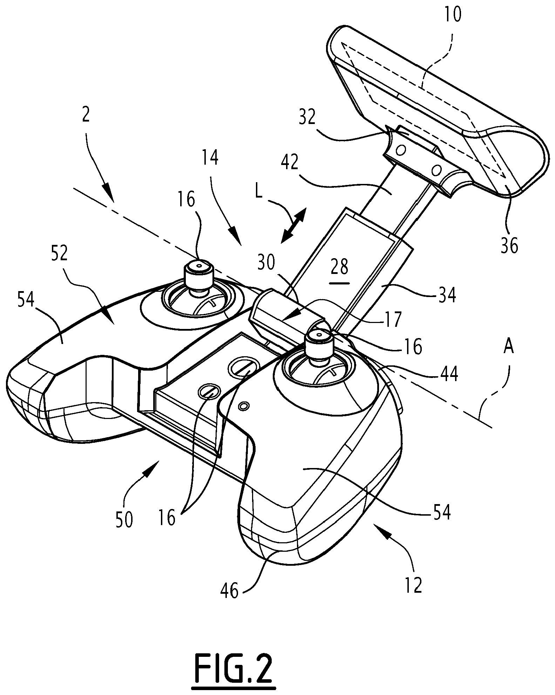

Le dispositif de commande à distance 2 possède une configuration de rangement (Figure 1), dans laquelle le dispositif de commande à distance 2 est compact, et une configuration d'utilisation (Figure 2 et 3), dans laquelle le dispositif de commande à distance 2 est propre à recevoir l'appareil électronique mobile 6 de manière amovible.

L'appareil électronique mobile 6 est par exemple un ordiphone ou une tablette numérique.

L'appareil électronique mobile 6 présente par exemple une forme générale de plaque rectangulaire, au moins une des deux faces opposées de l'appareil électronique mobile étant munie d'un écran d'affichage 8 pour l'affichage d'images.

L'appareil électronique mobile 6 reçu sur le dispositif de commande à distance 2 permet par exemple d'afficher sur l'écran 8 des paramètres de pilotage de l'appareil télécommandé 4, des paramètres de vol de l'appareil télécommandé 4, des données acquises via un capteur embarqué sur l'appareil télécommandé 4 et/ou des images prises par un appareil de capture d'image embarqué sur l'appareil télécommandé 4.

De préférence, le dispositif de commande à distance 2 est configuré pour établir une communication avec l'appareil électronique mobile, par une liaison filaire ou sans fil, par exemple une liaison sans fil de type Bluetooth®, Wifi® ou en champ proche (ou NFC pour « Near Field Communication » en anglais).

La communication entre le dispositif de commande à distance 2 et l'appareil électronique mobile 6 est par exemple configurée pour que le dispositif de commande à distance 2 puisse transmettre des données à l'appareil électronique mobile 6 et/ou recevoir des données de l'appareil électronique mobile 6. La communication est unidirectionnelle ou bidirectionnelle

Le dispositif de commande à distance 2 est configuré pour transmettre des signaux à l'appareil télécommandé 4 et/ou pour recevoir des signaux émis par l'appareil télécommandé 4.

Des signaux transmis à l'appareil télécommandé 4 sont par exemple des signaux de pilotage de l'appareil télécommandé 4 ou des signaux de commande d'un ou plusieurs équipement(s) embarqué(s) sur l'appareil télécommandé 4, par exemple un capteur embarqué sur l'appareil télécommandé 4, un appareil de capture d'image embarqué sur l'appareil télécommandé 4 et/ou un support orientable par l'intermédiaire duquel l'appareil de capture d'image est monté sur l'appareil télécommandé 4.

Des signaux reçus de l'appareil télécommandé 4 sont par exemple des signaux relatifs à des paramètres de vol du drone déterminés par exemple par une centrale inertielle de l'appareil télécommandé 4 ou un récepteur de géolocalisation intégré à l'appareil télécommandé 4 et/ou des images fournies par un appareil de prise d'image embarqué sur l'appareil télécommandé 4.

Le dispositif de commande à distance 2 est par exemple configuré pour transmettre des signaux vers l'appareil télécommandé 4 et/ou recevoir des signaux provenant de l'appareil télécommandé 4 par ondes radiofréquences. Le dispositif de commande à distance 2 est alors une « radiocommande ».

Le dispositif de commande à distance 2 comprend par exemple un système antennaire 10 de radiocommunication pour la communication avec l'appareil télécommandé 4 par ondes radiofréquences.

Le système antennaire 10 comprend une ou plusieurs antennes de radiocommunication, par exemple une antenne d'émission/réception, une antenne d'émission et/ou une antenne de réception.

Le système antennaire 10 comprend par exemple plusieurs antennes différentes configurées pour des radiocommunications dans des gammes de fréquences distinctes.

Le dispositif de commande à distance 2 comprend un corps principal 12 configuré pour être saisie par l'utilisateur lors de l'utilisation du dispositif de commande à distance 2, et un ensemble de support 14 configuré pour recevoir l'appareil électronique mobile 6 de manière amovible.

Le corps principal 12 porte par exemple des organes de commande 16 actionnables manuellement par un utilisateur, par exemple pour commander l'appareil télécommandé 4, pour commander un ou plusieurs équipement(s) embarqué(s) sur l'appareil télécommandé 4, pour commander le dispositif de commande à distance 2 lui-même et/ou pour commander l'appareil électronique mobile 6 reçu sur le dispositif de commande à distance 2.

Les organes de commande 16 comprennent par exemple des leviers de commande et/ou des boutons de commande.

Un levier de commande se présente par exemple sous la forme d'une manette (ou « joystick » en anglais) monté pivotante par rapport au corps principal, par exemple par le biais d'une liaison pivot, d'une liaison rotule ou d'un joint de cardan.

Un bouton de commande est par exemple un bouton poussoir ou un bouton coulissant (ou « curseur »).

Les organes de commande 16 comprennent ici deux leviers de commande. De tels organes de commande 16 sont classiquement utilisé pour piloter à distance un appareil télécommandé 4 tel qu'un drone.

L'ensemble de support 14 est monté mobile sur le corps principal 12 entre la configuration de rangement (Figure 1), dans laquelle l'ensemble de support 14 est ramené vers le corps principal 12 pour un rangement compact du dispositif de commande à distance 2, et la configuration d'utilisation (Figure 2), dans laquelle l'ensemble de support 14 est déployé pour recevoir un appareil électronique mobile 6.

L'ensemble de support 14 est par exemple articulé sur le corps principal 12 de façon à être replié contre le corps principal 12 dans la configuration de rangement et déplié à l'écart du corps principal 12 pour être disposé dans la configuration d'utilisation.

L'ensemble de support 14 est par exemple articulé sur le corps principal autour d'un axe de rotation A, par l'intermédiaire d'une articulation 17.

L'articulation 17 comprend par exemple des tourillons 18 reçus à rotation dans des paliers 20. Dans l'exemple illustré, les tourillons 18 sont situés sur l'ensemble de support 14 et les paliers 20 sont situés sur le corps principal. En variante, les positions sont inversées.

Le dispositif de commande à distance 2 peut être sélectivement mis sous tension (i.e. mis en marche ou allumé) ou mis hors tension (i.e. mis à l'arrêt ou éteint)

Le dispositif de commande à distance 2 est configuré de sorte que le passage de l'ensemble de support 14 de la configuration de rangement à la configuration d'utilisation provoque automatiquement la mise sous tension du dispositif de commande à distance 2 et/ou de manière que le passage de l'ensemble de support 14 de la configuration d'utilisation à la configuration de rangement provoque automatiquement la mise hors tension du dispositif de commande à distance 2.

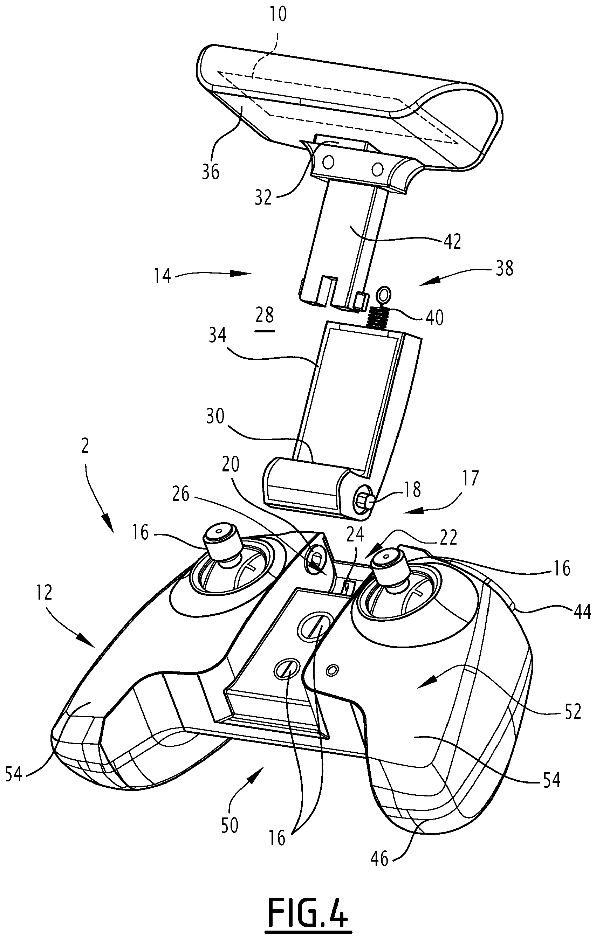

Le dispositif de commande à distance 2 comprend ici un interrupteur 22 de mise sous tension (Figure 4) qui est disposé de façon à être actionné par l'ensemble de support 14 lors de son passage de la configuration de rangement à la configuration d'utilisation.

L'interrupteur 22 est ici disposé sur le corps principal 12.

L'interrupteur 22 comprend par exemple un organe d'actionnement 24 déplaçable pour sélectivement fermer ou ouvrir l'interrupteur 22, et ainsi mettre le dispositif de commande à distance 2 sous tension ou hors tension.

L'interrupteur 22 est disposé de manière que l'organe d'actionnement 24 est déplacé par l'ensemble de support 14 lors de son déplacement entre la configuration de rangement et la configuration d'utilisation.

De préférence, l'organe d'actionnement 24 est disposé de manière à être recouvert et caché par l'ensemble de support 14 au moins lorsque l'ensemble de support 14 est en configuration de rangement.

L'organe d'actionnement 24 est ici situé à proximité de l'articulation 17 reliant le corps principal 12 et l'ensemble de support 14. Cette position permet à l'interrupteur 22 d'être intégré de manière discrète.

Le corps principal 12 possède ici un dégagement 26 permettant le débattement angulaire de l'ensemble de support 14 par rapport au corps principal 12 lors de sa rotation entre la configuration de rangement à la configuration d'utilisation, et l'organe d'actionnement 24 est disposé dans le fond de ce dégagement 26.

L'organe d'actionnement 24 ainsi positionné est masqué en permanence par l'ensemble de support 14.

L'ensemble de support 14 comprend une surface d'actionnement 26 destinée à venir en contact avec l'organe d'actionnement 24 lors du déplacement de l'ensemble de support 14 par rapport au corps principal 12, de manière à actionner l'organe d'actionnement 24.

En configuration d'utilisation, l'ensemble de support 14 délimite un espace de réception 28 pour recevoir l'appareil électronique mobile 6.

L'ensemble de support 14 est par exemple configuré pour maintenir l'appareil électronique mobile 6 par serrage de l'appareil électronique mobile 6, par exemple sur deux bords opposés de l'appareil électronique mobile 6.

L'ensemble de support 14 possède une première surface d'appui 30 et une deuxième surface d'appui 32 sensiblement en regard et prévues pour serrer l'appareil électronique mobile 6 entre elles, par exemple en venant en appui sur des bords opposés de l'appareil électronique mobile 6.

De préférence, l'ensemble de support 14 est réglable de manière à pouvoir faire varier la distance entre la première surface d'appui 30 et la deuxième surface d'appui 32 en fonction des dimensions de l'appareil électronique mobile 6.

L'ensemble de support 14 comprend une première partie 34 et une deuxième partie 36 portant respectivement la première surface d'appui 30 et la deuxième surface d'appui 32, la première partie 34 et la deuxième partie 36 étant mobiles en translation l'une par rapport à l'autre suivant une direction de réglage L de manière à faire varier la distance entre la première surface d'appui 30 et la deuxième surface d'appui 32.

L'ensemble de support 14 est déplacé entre la configuration de rangement et la configuration d'utilisation par déplacement de la première partie 34 par rapport au corps principal 12, l'ensemble de support est réglé en fonction des dimensions l'appareil électronique mobile 6 en déplaçant la deuxième partie 36 en translation par rapport à la première partie 34.

L'ensemble de support 14 comprend un système de rappel 38 configuré pour rapprocher la première surface d'appui 30 et la deuxième surface d'appui 32 l'une de l'autre. Ceci permet de serrer automatiquement l'appareil électronique mobile 6 entre la première surface d'appui 30 et la deuxième surface d'appui 32.

Le système de rappel 38 est ici configuré pour agir sur la première partie 34 et la deuxième partie 36 dans le sens d'un rapprochement de la première surface d'appui 30 et la deuxième surface d'appui 32 l'une de l'autre.

Le système de rappel 38 comprend par exemple un ressort de rappel 40 (Figure 4) agencé entre la première partie 34 et la deuxième partie 36 de manière à rétracter la deuxième partie 36 vers la première partie 34.

La première partie 34 et la deuxième partie 36 sont par exemple montées de manière télescopique l'une sur l'autre.

Dans l'exemple illustré, la première partie 34 est montée mobile sur le corps principal 12, ici par l'intermédiaire de l'articulation 17, et la deuxième partie 36 est montée de manière télescopique sur la première partie 34.

La deuxième partie 36 est liée à la première partie 34 par l'intermédiaire d'un élément de liaison 42 monté télescopique avec la première partie 34 suivant la direction de réglage L.

L'élément de liaison 42 et la première partie 34 sont emboîtés et coulissant l'un dans l'autre. L'élément de liaison 42 est ici emboîté et coulissant dans la première partie 34.

La première partie 34 présente une forme allongée suivant la direction de réglage L. La première partie 34 est liée au corps principal à son extrémité opposée à la deuxième partie 36. La première surface d'appui 30 est formée à l'extrémité de la première partie 34 liée au corps principal 12.

L'ensemble de support 14 présente une forme générale en « T », dont la hampe est formée par la première partie 34 et la barre est formée par la deuxième partie 36.

Dans l'exemple illustré, la première partie 34 est allongée suivant la direction de réglage L et la deuxième partie 36 est allongée perpendiculairement à la direction de réglage L.

Dans une variante possible, l'ensemble de support 14 présente une forme générale en «Y» dont la hampe est formée par la première partie 34 et dont les deux bras sont formés par deux portions de la deuxième partie 36 divergent l'une de l'autre.

Le corps principal 12 présente ici un bord avant 44 prévu pour être dirigé vers l'avant (du point de vue de l'utilisateur) lorsque l'utilisateur tient le dispositif de commande à distance 2 de manière appropriée, et un bord arrière 46.

L'ensemble de support 14 est configuré de façon que l'appareil électronique mobile 6 reçu dans l'ensemble de support 14 s'étend le long du bord avant 44. Ceci permet une disposition ergonomique de l'appareil électronique mobile 6, devant les mains de l'utilisateur.

L'ensemble de support 14 est par exemple articulé sur le corps principal 12 par l'intermédiaire de l'articulation 17 disposée le long du bord avant 46 du corps principal 12.

L'ensemble de support 14 en configuration de rangement est rabattu contre le corps principal 12 pour limiter l'encombrement du dispositif de commande à distance 2, et ainsi permettre un rangement compact and un transport facile.

Comme illustré sur les Figures 1 à 4, en option, le corps principal 12 et l'ensemble de support 14 sont prévus pour s'emboîter l'un dans l'autre en configuration de rangement.

L'ensemble de support 14 est ici configuré pour s'emboîter dans un logement de réception 50 délimité dans le corps principal 12 en configuration de rangement. Ceci favorise la compacité et protège l'ensemble de support 14, par exemple lors du transport du dispositif de commande à distance 2.

L'ensemble de support 14 est ici configuré pour en position rabattue compléter une face supérieure 52 du corps principal 12. Le logement de réception 50 est formé dans la face supérieure 52.

De préférence, le logement de réception 50 est de forme sensiblement complémentaire de celle de l'ensemble de support 14.

Le corps principal 12 possède ici deux parties latérales 54, chaque partie latérale 54 formant une poignée de préhension permettant à l'utilisateur de saisir le corps principal 12 à deux mains, chaque main saisissant une partie latérale 54 respective. Le logement de réception 50 est délimité entre les deux parties latérales 54.

Chaque partie latérale 54 porte par exemple un organe de commande 16 respectif sous la forme d'un levier de commande, l'organe de commande 16 étant placé à l'avant de la partie latérale de façon que l'utilisateur puisse manipuler l'organe de commande 16 à l'aide du pouce de la main saisissant cette partie latérale 54.

En configuration de rangement, la première partie 34 de l'ensemble de support 14 est plaquée sur le corps principal 12 entre les deux organes de commande 16.

Le logement de réception 50 s'étend ici entre le bord avant 44 du corps principal 12 et le bord arrière 46 du corps principal 12.

Dans l'exemple illustré, le logement de réception 50 débouche sur le bord arrière 46. Le bord arrière 46 présente un évidement formé par le logement de réception 50. Cet évidement facilite la préhension des parties latérales 54 par l'utilisateur.

La forme générale en « T » ou en « Y » de l'ensemble de support 14 articulé sur le corps principal 12 par la base de sa hampe permet d'avoir un ensemble de support 14 qui puisse être situé à l'avant du corps principal 12 en configuration d'utilisation, ce qui est ergonomique, tout en étant replié vers l'arrière du corps principal 12 en configuration de rangement, la hampe se rabattant ici sur le corps principal 12 entre des organes de commande 16 prévus par exemple sous la forme de leviers de commande, la barre ou les bras venant se loger dans la région arrière du corps principal 12.

En option, le corps principal 12 porte un ou plusieurs organe(s) de commande 16 recouvert(s) par l'ensemble de support 14 en configuration de rangement. Le corps principal 12 comprend ici deux organes de commande 16 recouverts par l'ensemble de support 14 en configuration de rangement.

Chaque organe de commande 16 recouvert par l'ensemble de support 14 en configuration de rangement est par exemple situé dans le logement 50 de réception de l'ensemble de support 14, en particulier sur un fond du logement 50.

Chaque organe de commande 16 recouvert par l'ensemble de support 14 en configuration de rangement est par exemple un bouton poussoir ou un curseur.

Comme illustré sur les Figures 1 à 4, le système antennaire 10 est porté par l'ensemble de support 14 de façon à être déployée lorsque l'ensemble de support 14 est en configuration d'utilisation.

Ceci permet de déployer le système antennaire 10 du fait du déploiement de l'ensemble de support 12, ce qui permet d'obtenir un dispositif de commande à distance 2 pouvant être rangé de manière compacte, tout en limitant le nombre d'opérations nécessaires pour déployer le dispositif de commande à distance 2. L'utilisation du dispositif de commande à distance 2 est donc facilitée pour l'utilisateur.

Le système antennaire 10 est de préférence situé à l'extrémité de l'ensemble de support 14 opposée à son extrémité liée au corps principal 12. Ainsi, en configuration déployée, le système antennaire 10 est éloigné du corps principal 12 et de l'utilisateur et se situe au-dessus de l'appareil électronique mobile 6. Il en résulte de moindres perturbations des radiocommunications effectuées via le système antennaire 10.

Le système antennaire 10 est par exemple porté par la deuxième partie 36 de l'ensemble de support 14.

Le système antennaire 10 est par exemple porté par la barre de l'ensemble de support 14 en forme générale de « T » ou par un des bras ou les deux bras de l'ensemble de support 14 en forme générale de « Y ». Cette disposition permet d'orienter le système antennaire 10 de manière appropriée pour de bonnes radiocommunications.

Le système antennaire 10 portée par l'ensemble de support est avantageuse indépendamment de la mise sous tension et/ou la mise hors tension du dispositif de commande à distance 2 automatiquement du fait du déplacement de l'ensemble de support 14 entre la configuration de rangement et la configuration d'utilisation.

Ainsi, l'invention concerne également de manière générale un dispositif de commande à distance 2 par signaux radiofréquences (ou radiocommande), le dispositif de commande à distance 2 comprenant un corps principal 12, un ensemble de support 14 configuré pour recevoir un appareil électronique mobile 16 et le maintenir solidaire du corps principal 12, l'ensemble de support 14 étant monté mobile sur le corps principal 12 entre une configuration de rangement et une configuration d'utilisation permettant de recevoir l'appareil électronique mobile 6, et un système antennaire 10 radiofréquence pour l'émission et/ou la réception de signaux radiofréquences, le système antennaire 10 étant porté par l'ensemble de support 14 de manière à être déployée lors du passage de la configuration de rangement à la configuration d'utilisation.

Selon un mode de réalisation particulier, un tel dispositif de commande à distance 2 peut comprendre une ou plusieurs des caractéristiques suivantes, prises individuellement ou selon toutes les combinaisons techniquement possibles :
- en configuration d'utilisation, l'ensemble de support 14 a une extrémité liée au corps principal 12 et une extrémité libre opposées, Le système antennaire 10 étant situé à proximité de l'extrémité libre de l'ensemble de support 14 ;
- en configuration d'utilisation, l'ensemble de support 14 s'étend en porte-à-faux à partir du corps principal 12 ;
- l'ensemble de support 14 est en forme générale de « T », dont la hampe est reliée à sa base au corps principal 12 et s'étend, en configuration d'utilisation, en porte-à-faux à partir du corps principal 12, le système antennaire 10 étant porté par la barre du « T ».
- l'ensemble de support 14 est en forme générale de « Y », dont la hampe est reliée à sa base au corps principal 12 et s'étend, en configuration d'utilisation, en porte-à-faux à partir du corps principal 12, l'antenne étant portée par un des bras ou les deux bras du « Y ».

L'ensemble de support 14 en forme générale de « T » ou de « Y » articulé à la base de sa hampe sur le corps principal 12 est avantageux indépendamment de la mise sous tension et/ou la mise hors tension du dispositif de commande à distance 2 automatiquement du fait du déplacement de l'ensemble de support 14 entre la configuration de rangement et la configuration d'utilisation et du positionnement du système antennaire 10 sur l'ensemble de support 14, en particulier sur la barre de l'ensemble de support en forme générale de « T » ou sur l'un des bras ou les deux bras de l'ensemble de support en forme générale de « Y ».

Ainsi, l'invention concerne également de manière générale un dispositif de commande à distance 2 comprenant un corps principal 12, un ensemble de support 14 configuré pour recevoir un appareil électronique mobile 6 et le maintenir solidaire du corps principal, l'ensemble de support 14 étant monté mobile sur le corps principal 12 entre une configuration de rangement et une configuration d'utilisation permettant de recevoir l'appareil électronique mobile 6, l'ensemble de support 14 présentant une forme générale de « T » ou de « Y », la base de la hampe de l'ensemble de support 14 étant liée au corps principal 12 pour le déplacement entre la configuration de rangement et la configuration d'utilisation.

Selon des modes de réalisation particuliers, un tel dispositif de commande à distance 2 peut comprendre une ou plusieurs des caractéristiques suivantes, prises individuellement ou selon toutes les combinaisons techniquement possibles :
- la hampe est articulée à sa base sur le corps principal 12 ;
- la hampe s'étend, en configuration d'utilisation, en porte-à-faux à partir du corps principal 12,
- l'ensemble de support en forme générale de « T » dont la barre étant située à l'extrémité de la hampe opposée au corps principal 12 ;
- l'ensemble de support en forme générale de « Y » dont les bras sont situés à l'extrémité de la hampe opposée au corps principal 12 ;
- l'ensemble de support 14 possède une première surface d'appui 30 et une deuxième surface d'appui 32 situées respectivement à la base de la hampe et sur la barre dans le cas d'une forme générale en « T » ou sur un des bras ou sur les deux bras dans le cas d'une forme générale en « Y »;
- la barre est montée de manière télescopique sur la hampe ou les bras sont montés télescopique sur la hampe pour permettre d'adapter l'ensemble de support en fonction des dimensions de l'appareil électronique reçu dans l'ensemble de support ;
- en configuration de rangement, la hampe et/ou la barre ou les bras s'emboîtent dans un logement de réception ménagé dans le corps principal 12 ;
- le corps principal 12 porte deux organes de commande 16 situés de part et d'autre de l'ensemble de support 14 rabattu sur le corps principal 14, la hampe passant entre les deux organes de commande 16 ;
- en configuration d'utilisation, l'ensemble de support 14 s'étend à l'avant du corps principal 12, la hampe rejoignant le corps principal 12 à proximité d'un bord avant du corps principal.

L'invention n'est pas limitée aux exemples de réalisation décrit ci-dessus. Des variantes sont envisageables.

Dans une variante possible, l'interrupteur 22 comprenant un organe d'actionnement 24 mobile est remplacé par un interrupteur 22 à commande magnétique, dont l'ouverture et la fermeture est commandée en fonction de la position d'un aimant par rapport à l'interrupteur 22.

L'interrupteur 22 par exemple disposé sur l'un du corps 12 et de l'ensemble de support 14, l'aimant étant disposé sur l'autre, de sorte que l'aiment se rapproche de l'interrupteur 22 lors de la fermeture de l'ensemble de support 14 pour commander la mise hors tension du dispositif de commande à distance 2, et s'éloigne de l'interrupteur 22 lors de la fermeture de l'ensemble de support 14 pour commander la mise sous tension du dispositif de commande à distance 2. Dans un exemple de réalisation particulier, l'interrupteur 2 est par exemple disposé sur le corps principal, l'aimant de commande étant disposé sur l'ensemble de support 14.

## Revendications

1. Dispositif de commande à distance comprenant un corps principal (12) et un ensemble de support (14) configuré pour recevoir un appareil électronique mobile (6) de manière amovible et le maintenir, l'ensemble de support (14) possédant une configuration de rangement et une configuration d'utilisation permettant de recevoir l'appareil électronique mobile (6), le dispositif de commande à distance étant configuré de telle sorte que le passage de la configuration de rangement à la configuration d'utilisation commande la mise sous tension du dispositif de commande à distance.

2. Dispositif de commande à distance selon la revendication 1, comprenant un interrupteur (22) commandant la mise sous tension/hors tension du dispositif de commande à distance, l'interrupteur (22) étant disposé de manière à être commandé du fait du passage de l'ensemble de support (14) de la configuration de rangement à la configuration d'utilisation.

3. Dispositif de commande à distance selon la revendication 2, dans lequel l'interrupteur (22) possède un organe d'actionnement (24) mobile disposé de manière à être actionné du fait du passage de l'ensemble de support (14) de la configuration de rangement à la configuration d'utilisation.

4. Dispositif de commande à distance selon la revendication 3, dans lequel l'organe d'actionnement (24) est placé de manière à être caché par l'ensemble de support (14) en configuration de rangement.

5. Dispositif de commande à distance selon la revendication 3 ou la revendication 4, dans lequel l'organe d'actionnement (24) est placé dans un dégagement (26) ménagé dans le corps principal (12) pour permettre le débattement de l'ensemble de support (14) entre la configuration de rangement et la configuration d'utilisation.

6. Dispositif de commande à distance selon l'une quelconque des revendications précédentes, dans lequel l'ensemble de support (14) est lié au corps principal (12) par une articulation (17).

7. Dispositif de commande à distance selon l'une quelconque des revendications précédentes, comprenant un système antennaire (10) de radiocommunication pour l'émission et/ou la réception de signaux radiofréquences, le système antennaire (10) étant porté par l'ensemble de support (14).

8. Dispositif de commande à distance selon la revendication 7, dans lequel le passage de l'ensemble de support de la configuration de rangement à la configuration d'utilisation entraîne le positionnement de du système antennaire (10) en position d'émission et/ou réception.

9. Dispositif de commande à distance selon l'une quelconque des revendications précédentes, dans lequel, en configuration de rangement, l'ensemble de support (14) est rabattu contre le corps principal (12) et, en configuration d'utilisation, l'élément de support (14) s'étend à partir du corps principal (12) et à l'écart du corps principal (12).

10. Dispositif de commande à distance selon l'une quelconque des revendications précédentes, dans lequel l'ensemble de support (14) possède une première partie (34) et une deuxième partie (36) délimitant entre elle un espace de réception de l'appareil électronique mobile, la première partie (34) étant montée mobile sur le corps principal (12) pour passer la configuration de rangement à la configuration d'utilisation, la deuxième partie (36) étant montée mobile sur la première partie (34) de manière à régler l'ensemble de support (14) en fonction de dimensions de l'appareil électronique mobile (6).

11. Dispositif de commande à distance selon l'une quelconque des revendications précédentes, comprenant des organes de commande (16) situés sur le corps principal (12) et actionnables par un utilisateur pour générer des instructions.
